# EUROPEAN PATENT APPLICATION

(11) **EP 1 077 243 A2**
(43) Date of publication of application: **21.02.2001**
(21) Application number: 00114905.3
(22) Date of filing: 14.07.2000
(51) Int. Cl.: C09J 7/02

(54) **Film adhesive composition for electronic packaging**

(30) Priority: 16.08.1999 US 375342
(71) Applicant: National Starch and Chemical Investment Holding Corporation, Wilmington, Delaware 19803-7663 (US)
(72) Inventor: He, Xiping, Lakewood, CA 90715 (US); Wu, Bing, Marina del Rey, CA 90292 (US); Dominic, Christopher J., Westminster, CA 92683 (US); Shenfield, David, Fountain Valley, CA (US)
(74) Representative: Held, Stephan, Dr.rer.nat., Dipl.-Chem.

(57) **Abstract**

A film adhesive uses a hydrophobic polymer carrier instead of the conventional polyimide carrier to achieve high moisture resistance while maintaining other adhesive properties. For use in electronic packaging.

## Description

This invention relates to an adhesive film for use in electronic packaging and the electronic device prepared using the film. The film adhesive uses a hydrophobic polymer carrier instead of the conventional polyimide carrier to achieve high moisture resistance while maintaining other adhesive properties.

Semiconductors are formed on silicon wafers that are diced into individual chips. The chips are mounted onto substrates, which act as mechanical support and means for interconnecting the chip to circuitry external to the chip. One technique for attaching the chip to the substrate entails the use of a film adhesive consisting of a carrier, commonly a polyimide film, coated on both sides with a thermoplastic or thermosetting adhesive. This is particularly common for memory packages. The application process involves a pretaping process consisting of punching out the film adhesive into a predetermined configuration and attaching the adhesive onto the substrate. The pretaped substrates will be shipped to a semiconductor packaging manufacturers that will attach the semiconductor chip, wire bond and encapsulate the package.

The semiconductor packaging industry trend is to use pretaping companies for memory devices. After the pretaping process, the substrates consisting of the adhesive tape will contact moisture during shipping and storage. The mostly commonly used polyimide carriers absorb moisture. The moisture is vaporized during subsequent manufacturing operations for attaching the chip onto the substrate, consequently causing voids in the bondline and potential failure of the ultimate electronic device. Currently, a prebaking process is commonly used prior to the die attach to reduce voiding caused by the moisture evaporation. Such a prebaking process significantly reduces the productivity.

It would be an advantage to provide an adhesive film for these manufacturing operations that has low moisture absorption to eliminate the prebaking process while maintains other required physical properties including sufficient adhesion strength, flexibility, high temperature resistance and dimensional stability required for adhering a semiconductor chip to a substrate.

It has now been discovered that when the adhesive film comprises a carrier layer of a polyester, and in particular of a poly(ethylene) naphthalate, the adhesive film has lower moisture absorption than films comprising a polyimide carrier and hence eliminate the prebaking process, while maintaining a commercially acceptable level of die shear strength, modulus, and dimensional stability.

The carrier for the adhesive film can be any flexible polyester film that has a Young's modulus in excess of 700,000 psi, a melting point greater than 260°C, and a glass transition temperature greater than 100°C. In one particular embodiment, the carrier is a polyethylene naphthalate film sold under the trademark KALADEX 2030 by DuPont.

The adhesive film may be made by any of the processes known in the art. In general, such films are made by coating onto a carrier with a solution of a thermoplastic polymer or a polymerizable thermoset monomer composition which can be thermally cured.

Representative thermoplastic polymers that are suitable for coating on the carrier film are polyimides, polyamides, polyesters, polycarbonates, polysulfones, polyacetals, polyvinyl halides, polyolefins, halogenated polyolefins, acrylic polymers, vinyl polymers, poly(phenylene sulfides), poly (ether sulfones), copolymers of bismaleimides and vinyl compounds, and thermoplastic epoxy resins.

Representative thermoset polymers that are suitable for coating on the carrier film are epoxy resins, rubber modified epoxy resins, phenoxy resins, and maleimide resins.

The adhesive composition can also contain inorganic fillers and pigments. Representative fillers include silica, titanium dioxide, alumina, and metallic fillers. The fillers can provide high temperature strength, thermal conductivity and required surface tackiness.

The following examples will serve to more fully describe the invention but are not to be deemed to be limiting.

### EXAMPLE 1

Two film adhesive tapes were prepared with the same formulation shown in Table 1, one using the inventive polyethylene naphthalate (PEN) carrier, and the other using a polyimide (PI) carrier. The proprietary rubber epoxy adduct and the proprietary urea catalyst are made by National Starch and Chemical Company. HM091 is a solid bisA epoxy resin made by Dainippon. The PEN film having a thickness of 50 microns (micron = 1 x 10⁻⁶m) was purchased under the trademark KALADEX 2030 from DuPont, and the PI film having a thickness of 50 microns was purchased under the trademark UPILEX SGA from Ube. The physical properties of these two carriers are shown in Table 2.

**Table 1**

| Formulation to make tape 1-PI and 1-PEN | |
|---|---|
| Formulation | %wt. in 100% solid |
| Proprietary rubber epoxy adduct | 83.63 |
| Silica filler | 4.88 |
| Dicyandiamide | 1.18 |
| Proprietary urea catalyst | 0.59 |
| HM091 | 9.72 |

**Table 2**

| Physical Properties of the PI and PEN carriers | | |
|---|---|---|
| | PI (Upilex SGA) | PEN (Kaladex 2030) |
| Tensile strength (MPa) | 390 | 200 |
| Young's Modulus (MPa) | 8,820 | 5,000 |
| Melting Point (°C) | None | 262 |
| Glass Transition Temperature (°C) | >500 | 120 |
| Moisture Uptake (85°C/85%RH) | 1.2% | 0.28% |

Adhesive tapes 1-PI and 1-PEN were made by solution coating the adhesive onto the PI and PEN carriers, respectively. The adhesive thickness was 25 microns in total or 12.5 microns on each side of the carrier. Die shear strength was tested at room temperature using a Daye 2400PC die shear tester. Dies of 80 milX80mil were adhered to a ceramic substrate using one of the adhesive coated tapes. Die shear strength was tested after cure, and tested again after exposing the cured test specimen to 85°C and 85% relative humidity in a Blue M moisture chamber for 90 hours. Lap shear strength was tested at room temperature using a United E. V. 60 lap shear tester. Young's modulus was measured using a Dynamic Mechanical Thermal Analyser MR III. The coefficient of thermal expansion was tested using a Perkin-Elmer TMA 7 Thermomechanical Analyzer. The moisture uptake was measured using a WTC Binder DVS-2000 moisture tester at 85°C/85%RH. A standard curing condition of 165°C/60 minutes was used in specimen preparation. The bubbling test was conducted by attaching a dry 1.9mm width tape onto a glass slide, preconditioning at 25°C/50%RH for two days and die attaching at 170°C. A visual test with an optical microscope was used to detect moisture-induced bubbles. The results are shown in Table 3.

**Table 3**

| Properties of PI and PEN Adhesive Tapes | | |
|---|---|---|
| Properties | 1-PI | 1-PEN |
| Lap shear strength (psi) | 1900 | 1400 |
| Die shear strength after cure (psi) | 4100 | 4400 |
| Die shear strength after 85/85 (psi) | 1050 | 1050 |
| Young's modulus at 25°C (psi) | 336,000 | 336,000 |
| Coefficient of Thermal Expansion (CTE) (ppm) Below Tg/above Tg | 101/295 | 166/320 |
| Moisture uptake (85°C/85%RH) | >2% | 1.2% |
| Bubbling test (25°C/50%RH) | fail | pass |

### EXAMPLE 2

Two film adhesive tapes were prepared with the same formulation shown in Table 4, one using the inventive polyethylene naphthalate (PEN) carrier, and the other using a polyimide (PI) carrier. The proprietary rubber epoxy adduct (2) and the proprietary urea catalyst are made by National Starch and Chemical Company.

**Table 4**

| Formulation to make tape 2-PI and 2-PEN | |
|---|---|
| Formulation | %wt. in 100% solid |
| Proprietary rubber epoxy adduct (2) | 95.4 |
| Silica filler | 2.7 |
| Dicyandiamide | 1.3 |
| Proprietary urea catalyst | 0.6 |

Adhesive tapes 2-PI and 2-PEN were made by solution coating the adhesive onto the PI and PEN carriers, respectively. The adhesive thickness was 100 microns in total or 50 microns on each side of the carrier. The physical properties of the two tapes are shown in Table 5.

**Table 5**

| Properties of PI and PEN Adhesive Tapes | | |
|---|---|---|
| Properties | 2-PI | 2-PEN |
| Lap shear strength (psi) | 1400 | 1300 |
| Die shear strength after cure (psi) | 1900 | 1700 |
| Young's modulus at 25°C (psi) | 53,000 | 53,000 |
| CTE (ppm) Below Tg/above Tg | 75/442 | 49/476 |
| Moisture uptake (85°C/85%RH) | 1.4% | 1.2% |
| Bubbling test (25°C/50%RH) | fail | pass |

## Claims

1. A film adhesive comprising a thermoset, thermoplastic, or β-staged polymer and a flexible polyester film carrier that has a Young's modulus in excess of 700,000 psi, a melting point greater than 260°C, and a glass transition temperature greater than 100°C.

2. The film adhesive according to claim 1 in which the flexible polyester film is a poly(ethylene) naphthalate.
